# EUROPEAN PATENT APPLICATION

(11) **EP 4 528 296 A1**
(43) Date of publication of application: **26.03.2025**
(21) Application number: 24199161.1
(22) Date of filing: 09.09.2024
(51) Int. Cl.: G01R 31/382

(54) **BATTERY STATE DETERMINATION METHOD AND BATTERY STATE DETERMINATION SYSTEM**

(30) Priority: 22.09.2023 JP 2023159159
(71) Applicant: Yokogawa Electric Corporation, Tokyo 180-8750 (JP); Honda Motor Co., Ltd., Tokyo 107-8556 (JP)
(72) Inventor: NOGUCHI, Naoki, Musashino-shi, Tokyo, 180-8750 (JP); TERAO, Minako, Musashino-shi, Tokyo, 180-8750 (JP); UEMURA, Hideo, Musashino-shi, Tokyo, 180-8750 (JP); OKANO, Jun, Wako-shi, Saitama, 3510193 (JP); ONOUE, Yukiko, Minato-ku, Tokyo, 1078556 (JP); TOMINAGA, Yuki, Wako-shi, Saitama, 3510193 (JP); OMICHI, Kaoru, Wako-shi, Saitama, 3510193 (JP)
(74) Representative: Stöckeler, Ferdinand

(57) **Abstract**

A method of determining the state of a battery (60) includes acquiring measurement values of a magnetic field of the battery (60), which is mounted on a device (80), measured by a magnetometer (20), calculating information regarding the relative position of the magnetometer (20) based on the measurement values of the magnetic field of the battery (60) and reference values of the magnetic field of the battery (60), and determining the state of the battery (60) based on the information regarding the relative position of the magnetometer (20).

## Description

### TECHNICAL FIELD

The present disclosure relates to a battery state determination method and a battery state determination system.

### BACKGROUND

Conventionally, apparatuses that inspect batteries by comparing the current distribution of a battery to be inspected with normal current distribution thereof are known. See, for example, Patent Literature (PTL) 1.

### CITATION LIST

### Patent Literature

PTL 1: JP 2020-187951 A

### SUMMARY

The current distribution of a battery, which is to be compared with normal current distribution, is measured with a current measurement apparatus that is positioned in accordance with a reference position of the battery. Accuracy in measuring the current distribution of the battery is affected by a positional misalignment of the measurement apparatus with respect to the reference position of the battery.

When the state of the battery is determined based on the measurement results of the current distribution of the battery, it is required to improve the accuracy of determination without increasing a measurement burden.

It would be helpful to provide a battery state determination method and a battery state determination system that can improve accuracy in determining the state of a battery without increasing a measurement burden on the battery.
(1) A battery state determination method according to some embodiments includes:
   acquiring a measurement value of a magnetic field of a battery mounted on a device, the measurement value being measured by a magnetometer;
   calculating information regarding a relative position of the magnetometer, based on the measurement value of the magnetic field of the battery and a reference value of the magnetic field of the battery; and
   determining the state of the battery based on the information regarding the relative position of the magnetometer.
   This allows a positional misalignment between the battery and the magnetometer. As a result, accuracy in determining the state of the battery is increased even when the battery is measured without being detached from the device.
(2) The battery state determination method according to (1) above may include determining that the battery is anomalous when the information regarding the relative position of the magnetometer satisfies an anomaly determination condition. This allows determining that the battery is anomalous, without correcting the measurement value. In other words, this eliminates unnecessary correction operations. As a result, an operation load of a control apparatus is reduced.
(3) The battery state determination method according to (1) or (2) above may include calculating, as the information regarding the relative position of the magnetometer, a correction coefficient for the relative position of the magnetometer. This allows a positional misalignment between the battery and the magnetometer.
(4) The battery state determination method according to any one of (1) to (3) above may include moving the magnetometer along one scan direction, to measure the magnetic field of the battery by the magnetometer. The control apparatus can thereby measure the distribution of the magnetic field generated by the battery.
(5) The battery state determination method according to (4) above may include shifting the magnetometer to each of multiple positions that are aligned periodically or non-periodically in a direction intersecting the scan direction, and moving the magnetometer from each of the positions along the scan direction. The control apparatus can thereby measure the planar distribution of the magnetic field generated by the battery.
(6) The battery state determination method according to (5) above may include shifting the magnetometer to each position from which, when the reference value of the magnetic field of the battery has been measured, movement to the scan direction has been started, and moving the magnetometer from each position along the scan direction. This allows the control apparatus to compare the measurement value with the reference value with high accuracy.
(7) The battery state determination method according to any one of (4) to (6) above may include:
   acquiring measurement values of the magnetic field of the battery by moving the magnetometer to multiple directions including at least first and second directions; and
   determining the scan direction based on a first measurement value and a second measurement value, the first measurement value being obtained by moving the magnetometer to the first direction, the second measurement value being obtained by moving the magnetometer to the second direction.
   The magnetometer is thereby moved so that the position of the battery is closer to a reference position. As a result, a positional or postural misalignment of the battery is reduced.
(8) The battery state determination method according to any one of (4) to (7) above may include moving the magnetometer in a scan range determined based on the type of the device on which the battery is mounted. This eliminates unnecessary scanning. As a result, measurement efficiency is increased.
(9) A battery state determination system according to some embodiments includes:
   a magnetometer; and
   a control apparatus configured to perform the battery state determination method according to any one of (1) to (8) above.
(10) The battery state determination system according to (9) above may further include a movement apparatus configured to move the magnetometer relative to the battery. The movement apparatus may be configured to move between a plane on which the device with the battery is disposed and the battery.
(11) The battery state determination system according to (9) or (10) above may further include a drive apparatus configured to move the device with the battery relative to the magnetometer. Therefore, accuracy in measuring the magnetic field of the battery or accuracy in determining the state of the battery is improved.
(12) In the battery state determination system according to any one of (9) to (11) above, the magnetometer may be configured to include one or more magnetic sensors to measure the magnetic field of the battery.
(13) In the battery state determination system according to (12) above, the magnetometer may be configured to include a plurality of the magnetic sensors arranged in a line or array. This reduces the number of scans by the magnetometer.
(14) In the battery state determination system according to (12) or (13) above, the magnetometer may be configured to include a plurality of the magnetic sensors arranged in a range of covering the entirety of the battery. This eliminates the need for scanning by the magnetometer.
(15) In the battery state determination system according to (14) above, the control apparatus may be configured to select part of the plurality of the magnetic sensors, and acquire measurement values from the selected magnetic sensors. The magnetometer is thereby pseudo moved.

The battery state determination method and the battery state determination system according to the present disclosure can reduce the influence of the position of a measurement apparatus.

### BRIEF DESCRIPTION OF THE DRAWINGS

In the accompanying drawings:
FIG. 1 is a side view illustrating an example of a positional relationship between a battery and a magnetometer;
FIG. 2 is a plan view illustrating the example of the positional relationship between the battery and the magnetometer;
FIG. 3 is a block diagram illustrating an example of a configuration of a battery state determination system according to an embodiment;
FIG. 4 is a flowchart illustrating an example of a procedure of a battery state determination method;
FIG. 5 is a diagram illustrating an example in which the battery is disposed so that an arrangement of battery cells is along a scan direction of the magnetometer;
FIG. 6 is a diagram illustrating an example in which the battery is disposed so that the arrangement of the battery cells is inclined with respect to the scan direction of the magnetometer;
FIG. 7 is a diagram illustrating an example in which the battery is disposed so that an arrangement plane of the battery cells is in parallel with a scan plane of the magnetometer;
FIG. 8 is a diagram illustrating an example in which the battery is disposed so that the arrangement plane of the battery cells is inclined with respect to the scan plane of the magnetometer;
FIG. 9 is a diagram illustrating an example in which the battery is disposed so that the distance between an array of the battery cells and a scan path of the magnetometer varies;
FIG. 10 is a graph illustrating an example of a waveform of measurement values of a magnetic field measured by the magnetometer when the position of the battery deviates in the scan direction of the magnetometer;
FIG. 11 is a graph illustrating an example of a waveform of the measurement values of the magnetic field measured by the magnetometer when the position of the battery deviates so as to increase the distance between the array of the battery cells and the scan path of the magnetometer;
FIG. 12 is a graph illustrating an example of a waveform of the measurement values of the magnetic field measured by the magnetometer when the position of the battery deviates so that the arrangement plane of the battery cells rotates around a rotation axis in a direction intersecting the scan direction of the magnetometer;
FIG. 13 is a three-dimensional graph illustrating an example of waveforms of the measurement values of the magnetic field along multiple scan paths, which are measured by moving the magnetometer along the scan paths;
FIG. 14 is a diagram illustrating an example in which the magnetometer is moved in two intersecting directions for a preliminary diagnosis of the array of the battery cells;
FIG. 15 is a side view illustrating an example of a movement apparatus that moves the magnetometer in the scan direction; and
FIG. 16 is a plan view illustrating an example of a drive apparatus that moves a vehicle on which the battery is mounted.

### DETAILED DESCRIPTION

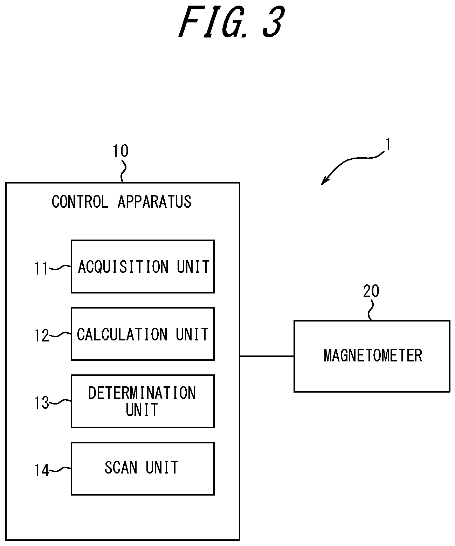

A magnetic field is generated when a charging or discharging current flows through a secondary battery. The state of the secondary battery may be inspected by measuring the magnetic field generated by charging and discharging the secondary battery. The battery, the magnetic field of which is to be measured, is, for example, a battery having an electrode body, in which positive active material layers and negative active material layers are overlaid via insulating layers, and an outer package containing the electrode body. Embodiments of a battery state determination method and a battery state determination system 1 (see FIG. 3) according to the present disclosure will be described below, in contrast to a comparative example.

### (Comparative Example)

An apparatus according to the comparative example acquires, in advance, data on the current distribution of a battery in a normal state by disposing the battery in the normal state at a reference position and measuring, with a magnetometer, a magnetic field when a reference current is applied to the battery in the normal state. The apparatus according to the comparative example acquires data on the current distribution of a battery to be inspected by disposing the battery to be inspected at the reference position and measuring, with the magnetometer, a magnetic field when the reference current is applied to the battery to be inspected. The apparatus according to the comparative example determines the state of the battery to be inspected by comparing the data on the current distribution of the battery to be inspected with the data on the current distribution of the battery in the normal state.

Here, a misalignment of the battery to be inspected from the reference position causes an error in the data on the current distribution of the battery to be inspected. The error in the data on the current distribution reduces accuracy in inspecting the state of the battery. In other words, the positional misalignment of the battery to be inspected affects accuracy in inspecting the state of the battery.

However, in the apparatus according to the comparative example, it is not always possible to accurately dispose the battery to be inspected at the reference position. For example, when the battery to be inspected is mounted on an electric vehicle, it is difficult to accurately replicate the position and posture of the vehicle. If the battery to be inspected is removed from the vehicle in order to accurately replicate the position and posture of the battery, work to remove the battery from the vehicle increases a workload and cost of battery inspection. Therefore, it is required to determine the state of the battery by taking into account the influence of the positional misalignment of the battery to be inspected.

Therefore, the battery state determination method and the battery state determination system 1 (see FIG. 3) according to the present disclosure determine the state of the battery, by taking into account the positional misalignment of the battery to be inspected, when the magnetic field of the battery is measured without the battery being detached from the device e.g. electric vehicle. The battery state determination method and the battery state determination system 1 according to an embodiment of the present disclosure will be described below.

### (Embodiment of the Present Disclosure)

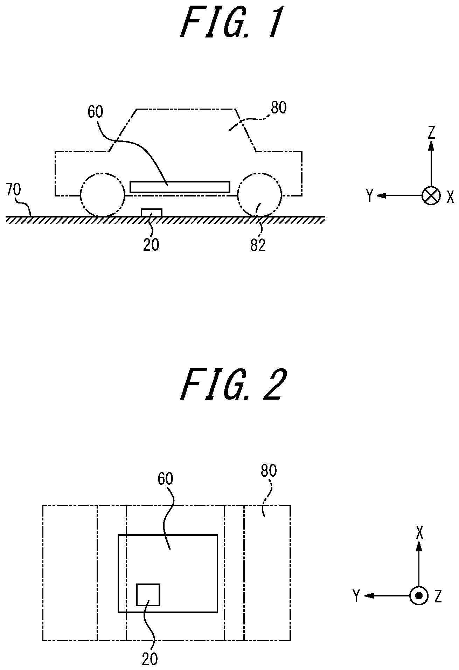

As illustrated in FIGS. 1 and 2, assume that a battery 60 to be inspected in the battery state determination system 1 according to the embodiment of the present disclosure is mounted on a vehicle 80. Assume that the vehicle 80 has tires 82 and touches the ground 70 with the tires 82. In this embodiment, the ground 70 is assumed to be along an XY plane. The normal direction (vertical direction) of the ground 70 corresponds to a Z-axis. Assume that a vertical upward direction corresponds to a positive direction of the Z-axis.

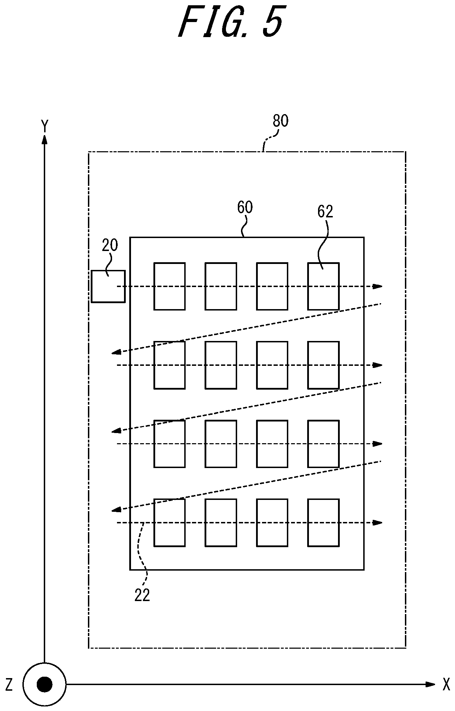

The battery 60 has cells 62 (see FIG. 5) arranged in a grid, as described below. Assume that the battery 60 is mounted on the vehicle 80 so that a plane on which the cells 62 are arranged is along the ground 70. A magnetometer 20 is installed on the ground 70 and measures a magnetic field generated by the battery 60. The magnetometer 20 may be configured to be movable on the ground 70 along the ground 70, i.e., along an arrangement direction of the cells 62 of the battery 60. The vehicle 80 may be configured to be movable relative to the magnetometer 20 along the ground 70, i.e., along the arrangement direction of the cells 62 of the battery 60.

### (Example of Configuration of Battery State Determination System 1)

As illustrated in FIG. 3, the battery state determination system 1 according to the embodiment of the present disclosure includes a control apparatus 10 and the magnetometer 20. The control apparatus 10 includes an acquisition unit 11, a calculation unit 12, a determination unit 13, and a scan unit 14. The acquisition unit 11 acquires, from the magnetometer 20, measurement results of the magnetic field of the battery 60. The magnetometer 20 scans the battery 60, so the acquisition unit 11 can acquire the distribution of the measurement results of the magnetic field of the battery 60. The calculation unit 12 calculates the current distribution of the battery 60 based on the measurement results of the magnetic field of the battery 60. The determination unit 13 determines the state of the battery 60 based on the current distribution of the battery 60. The scan unit 14 controls the position of the magnetometer 20 so as to have the magnetometer 20 scan the battery 60 when the magnetometer 20 is configured to be movable. The scan unit 14 moves the magnetometer 20 along one scan direction in order to measure the magnetic field of the battery 60 by scanning.

The acquisition unit 11 includes a communication device for communicable connection to the magnetometer 20 with wires or wirelessly. The communication device may include a communication module that transmits and receives data based on a data communication standard, such as RS-232C or RS-485. The communication device may include a communication module compatible with a mobile communication standard, such as the 4th Generation (4G) or Long Term Evolution (LTE) or the 5th Generation (5G). The communication device is not limited to the exemplified communication modules and may include various other devices or modules.

The calculation unit 12, the determination unit 13, or the scan unit 14 may be configured with a processor, such as a central processing unit (CPU). The calculation unit 12, the determination unit 13, or the scan unit 14 may realize a predetermined function by causing the processor to execute a predetermined program. The calculation unit 12, the determination unit 13, or the scan unit 14 may be configured such that a combination of at least some of the calculation unit 12, the determination unit 13, and the scan unit 14 is integrated into a single unit, or each of the calculation unit 12, the determination unit 13, and the scan unit 14 may be configured as separate units. The calculation unit 12, the determination unit 13, or the scan unit 14 is hereinafter also collectively referred to as a controller. The controller may include a memory. The memory may store various information used in operations of the controller, a program to realize the functions of the controller, or the like. The memory may function as a work memory of the controller. The memory may be composed of, for example, a semiconductor memory. The memory may be configured with volatile memory or nonvolatile memory. The memory may be included in the controller or may be configured separately from the controller.

The magnetometer 20 may include magnetic sensors that measure the magnetic field. The number of the magnetic sensors included in the magnetometer 20 is one or two or more. The magnetometer 20 may be constituted of the multiple magnetic sensors arranged in a line or array. When the magnetometer 20 scans the battery 60, as described above, the number of scans is reduced by arranging the magnetic sensors in the line or array. The reduced number of scans reduces measurement time of the magnetic field of the battery 60.

The magnetometer 20 may be constituted of the multiple magnetic sensors arranged in a range covering the entirety of the battery 60. Arranging the multiple magnetic sensors in the range covering the entirety of the battery 60 eliminates the magnetometer 20 having to scan the battery 60. The magnetometer 20 may select particular magnetic sensors, among the multiple magnetic sensors arranged in the range covering the entirety of the battery 60, and acquire measurement values from the selected particular magnetic sensors. In other words, the magnetometer 20 may select part of the multiple magnetic sensors arranged in the range covering the entirety of the battery 60, and acquire the measurement values from the selected part of the magnetic sensors. By acquiring the measurement values of the part of the magnetic sensors, a scan operation of the magnetic sensors is pseudo duplicated. The particular magnetic sensors may be selected from the magnetic sensors arranged at equally spaced intervals or the magnetic sensors arranged at arbitrary intervals that are not equally spaced.

The magnetic sensor may be configured to measure the magnetic field in one axis, or may be configured to measure the magnetic field in three axes simultaneously. Regardless of a direction of the measurement axis of the magnetic sensor, the magnetic sensor is preferably disposed so that a magnetic sensitive surface and the magnetic field generated by the battery 60 are orthogonal to each other. The reason why the magnetic sensor is disposed so that the magnetic sensitive surface and the magnetic field generated by the battery 60 are orthogonal to each other is that making a macro current of the battery 60 and the magnetic sensitive surface orthogonal to each other makes it easier to obtain the distribution of the magnetic field that reflects the orientation or disposition of the battery 60.

The magnetic sensor may have at least one magnetic element. The magnetic element may be an analog or digital element. The magnetic element may include a magnetic resistance element, such as a Hall element, an anisotropic magnetoresistance (AMR) element, a giant magnetoresistance (GMR) element, or a tunnel magnetoresistance (TMR) element. The magnetic element may include, for example, a magnetic impedance element, such as a Magneto-Impedance (MI) element, or a flux gate. The magnetic element may include, for example, a thin-film magnetic element with an anomalous Hall effect using a topological magnetic material. When an alternating current flows through the measurement object, a pickup coil may be used as the magnetic element.

The magnetometer 20 may include, other than the magnetic sensors, various other configurations that can measure the magnetic field.

### (Example of Operations of Battery State Determination System 1)

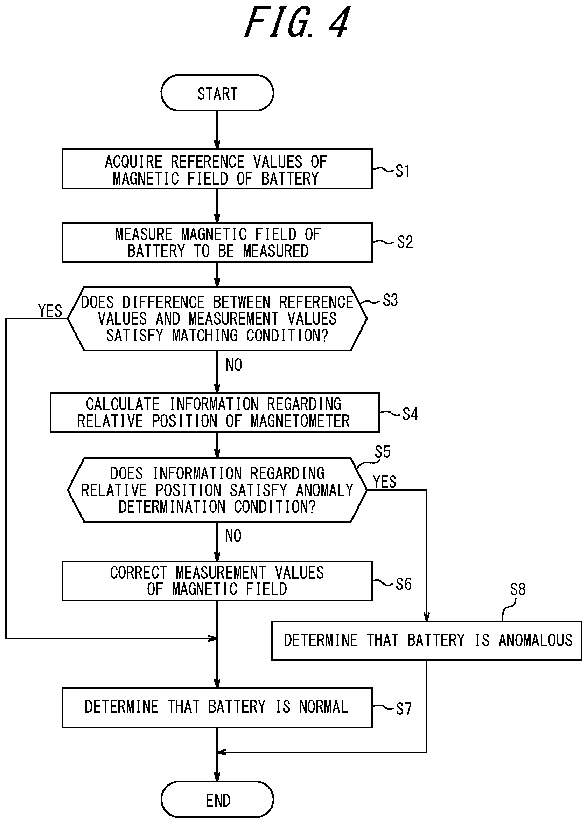

The battery state determination system 1 according to the embodiment of the present disclosure determines the state of the battery 60 by measuring the magnetic field of the battery 60. The control apparatus 10 may perform a method of determining the state of the battery 60 including a procedure in a flowchart illustrated in FIG. 4. The method of determining the state of the battery 60 may be realized as a battery state determination program to be executed by a processor that constitutes the control apparatus 10. The battery state determination program may be stored in a non-transitory computer readable medium.

The control apparatus 10 acquires reference values for the magnetic field of the battery 60 (step S 1). The reference values are measurement values of the magnetic field that are obtained by the magnetometer 20 scanning the battery 60 disposed at a reference position when the battery 60 is known to be in a normal state.

As illustrated in FIG. 5, the battery 60 has the cells 62 that are arranged in a grid along each of X-axis and Y-axis directions. In other words, the cells 62 are arranged on an arrangement plane along the XY plane. In this embodiment, the magnetometer 20 is assumed to scan the battery 60 in the X-axis direction. In other words, a scan direction 22 of the magnetometer 20 corresponds to the X-axis direction. The magnetometer 20 scans the battery 60 multiple times with shifting a scan start point in the Y-axis direction. In other words, the control apparatus 10 may control the magnetometer 20 to scan the battery 60 by moving the magnetometer 20 along the scan direction 22 from each position of multiple positions that are aligned periodically or non-periodically in a direction intersecting the scan direction 22. As illustrated in FIG. 5, the reference position of the battery 60 is an installation position of the battery 60 when the arrangement direction of the cells 62 coincides with the scan direction 22 of the magnetometer 20.

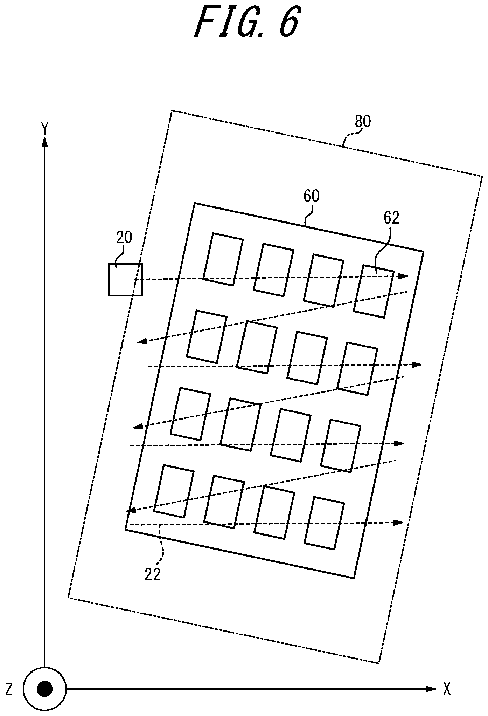

As illustrated in FIG. 6, the battery 60 may be positioned such that the arrangement direction of the cells 62 is inclined with respect to the X-axis and Y-axis directions. In other words, the scan direction 22 of the magnetometer 20 is inclined with respect to the arrangement direction of the cells 62. In this case, the installation position of the battery 60 deviates from the reference position. Therefore, the position and posture of the battery 60 or a device on which the battery 60 is mounted are adjusted, or the scan direction of the magnetometer 20 is adjusted so that the position of the battery 60 coincides with the reference position.

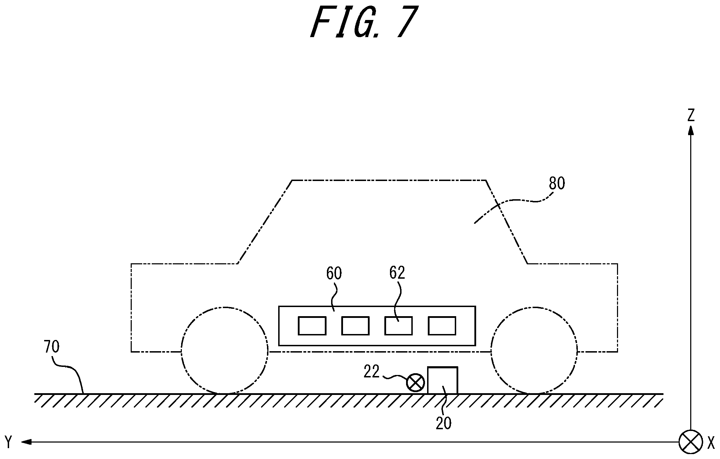

As illustrated in FIG. 7, assume that, when the battery 60 is mounted in the vehicle 80, the battery 60 is disposed such that the cells 62 are arranged along the XY plane. The magnetometer 20 is assumed to scan the battery 60 in the paper depth direction. The reference position of the battery 60 is the installation position of the battery 60 in a case in which the distance in a Z-axis direction between the magnetometer 20 and the arrangement plane of the cells 62 is constant when the magnetometer 20 scans the battery 60.

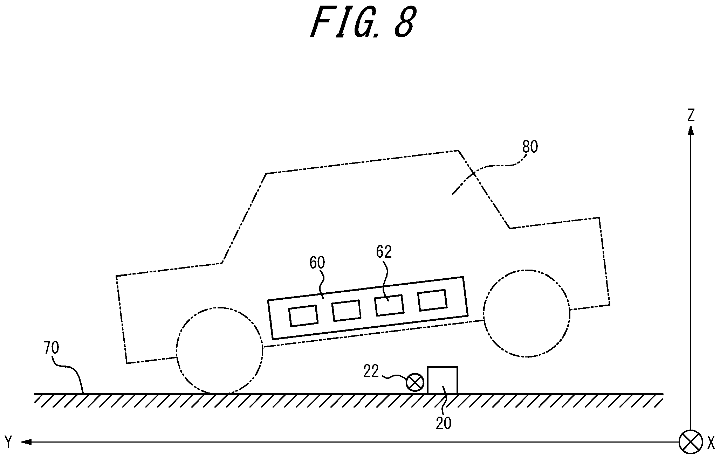

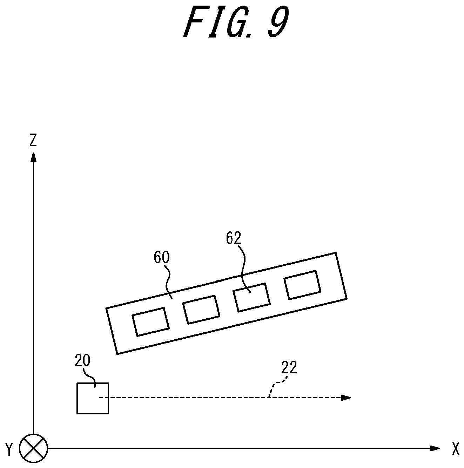

As illustrated in FIGS. 8 and 9, when the vehicle 80 on which the battery 60 is mounted is inclined with respect to the ground 70, the battery 60 may be positioned such that the arrangement plane of the cells 62 is inclined with respect to the XY plane. In the example in FIG. 8, the arrangement plane of the cells 62 is rotated around the X-axis. In other words, the arrangement plane of the cells 62 is in parallel with the X-axis and inclined with respect to the Y-axis direction. In the example of FIG. 9, the arrangement plane of the cells 62 is rotated around the Y-axis. In other words, the arrangement plane of the cells 62 is in parallel with the Y-axis and inclined with respect to the X-axis direction. In these cases, the installation position of the battery 60 deviates from the reference position. Therefore, the position and posture of the battery 60 or the device on which the battery 60 is mounted are adjusted, or the scan direction of the magnetometer 20 is adjusted so that the position of the battery 60 coincides with the reference position.

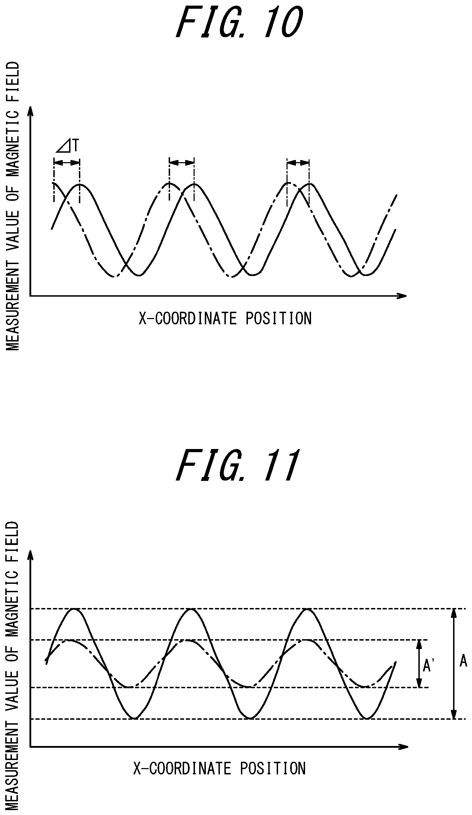

The reference values may be the measurement values of the magnetic field when the battery 60 is mounted on the device, or may be the measurement values of the magnetic field when the battery 60 is removed from the device. The reference values may be represented as a waveform (see, for example, the graph in FIG. 10) of the measurement values of the magnetic field that continues along the scan direction of the magnetometer 20. The reference values may be represented as a set of the measurement values of the magnetic field at discrete positions along the scan direction of the magnetometer 20. In this embodiment, the reference values are assumed to be represented as the continuous waveform. The waveform representing the reference values varies with a period corresponding to the distance between the cells 62. The waveform representing the reference values may be, for example, a sine wave or a waveform approximated by the sine wave. The waveform representing the reference values is not limited to the sine wave, but may be various other waveforms with periodicity, such as a triangular wave or a pulse wave.

The waveform representing the reference values is not limited to a waveform with a constant amplitude, such as the sine wave, but may include waveforms with varying amplitudes. The amplitude of the waveform representing the reference values can be constant when one positive pole and one negative pole alternate in a certain direction in an arrangement of poles of the battery 60. On the other hand, in the arrangement of the poles of the battery 60, the positive and negative poles may not alternate in a certain direction, and the number of positive or negative poles may be uneven in a limited section. For example, when the poles of the battery 60 are arranged in the order of a positive pole, a positive pole, a negative pole, a negative pole, and a positive pole, a waveform measured by extracting only a section in which the first two positive poles are arranged has a different amplitude than a waveform measured in a section including other sections. In other words, the amplitude of the waveform is not constant according to the section to be measured. Therefore, the waveform representing the reference values is not limited to the sine wave or the waveform approximated by the sine wave, but may be a waveform approximated by a polynomial with second or higher order. In other words, the waveform representing the reference values may be a waveform that is not periodic in at least some intervals.

The control apparatus 10 may acquire, by the acquisition unit 11, the reference values prepared in advance. The reference values of the magnetic field of the battery 60 may be prepared in advance in an external database. The reference values of the magnetic field of the battery 60 may be databased for each type of the battery 60. The reference values of the magnetic field of the battery 60 may be databased for each device with the battery 60. The control apparatus 10 may acquire the reference values, by moving the magnetometer 20 by the scan unit 14 and acquiring, by the acquisition unit 11, the measurement results of the magnetic field from the magnetometer 20, with the battery 60, which is known to be in the normal state, disposed in the reference position.

Returning to the flowchart in FIG. 4, the control apparatus 10 measures the magnetic field of the battery 60 to be measured (step S2). Assume that the device such as the vehicle 80 on which the battery 60 is mounted is disposed in such a position that the magnetic field of the battery 60 can be measured by the magnetometer 20. When the magnetometer 20 is configured to be movable, the control apparatus 10 moves the magnetometer 20 by the scan unit 14, and acquires, by the acquisition unit 11, the measurement results of the magnetic field generated by individual parts of the battery 60. When the device on which the battery 60 is mounted is configured to be movable, the control apparatus 10 controls the position of the device, and acquires, by the acquisition unit 11, the measurement results of the magnetic field generated by the individual parts of the battery 60.

To measure the magnetic field of the battery 60 to be measured, the control apparatus 10 may control the magnetometer 20 to scan the battery 60 multiple times, with shifting the scan start point in the Y-axis direction. In other words, the control apparatus 10 may control the magnetometer 20 to scan the battery 60 by moving the magnetometer 20 along the scan direction 22 from each position of the multiple positions that are aligned periodically or non-periodically in the direction intersecting the scan direction 22. The control apparatus 10 may shift the magnetometer 20 to each position from which the magnetometer 20 has started moving in the scan direction when the reference values of the magnetic field of the battery 60 have been measured, and move the magnetometer 20 along the scan direction from each position. In other words, the control apparatus 10 may move the magnetometer 20 in accordance with the scan start points when the reference values of the magnetic field of the battery 60 have been measured. By making the scan start points for measuring the magnetic field of the battery 60 to be measured coincide with the scan start points when the reference values of the magnetic field of the battery 60 have been measured, the control apparatus 10 can compare the measurement values with the reference values with high accuracy.

The control apparatus 10 determines, by the calculation unit 12, whether the difference between the reference values of the magnetic field of the battery 60 and the measurement values thereof satisfies a matching condition (step S3). The matching condition includes that the reference values of the magnetic field of the battery 60 and the measurement values thereof match, or that the difference between the reference values of the magnetic field of the battery 60 and the measurement values thereof is small.

FIGS. 10 to 12 each illustrate an example of the waveform of the measurement values of the battery 60 when the installation position of the battery 60 deviates from the reference position. The horizontal axis of each graph in FIGS. 10 to 12 is X-coordinate position corresponding to the position in the X-axis direction. The vertical axis is the measurement value of the magnetic field at each position. A waveform of a solid line represents the reference values. A waveform of a single-dotted line represents the measurement values.

In FIG. 10, the phase of the waveform of the measurement values is shifted in the X-axis direction by ΔT relative to the phase of the waveform of the reference values. In this case, the installation position of the battery 60 deviates from the reference position in the X-axis direction. The calculation unit 12 may determine that the matching condition is satisfied when ΔT, i.e., the difference between the phase of the waveform of the measurement values and the phase of the waveform of the reference values, is less than a phase threshold. Conversely, the calculation unit 12 may determine that the matching condition is not satisfied when ΔT, i.e., the difference between the phase of the waveform of the measurement values and the phase of the waveform of the reference values, is equal to or more than the phase threshold. The phase threshold may be set as appropriate. As described above, the fact that the battery 60 deviates in the X-axis direction without changing the posture of the battery 60 in the reference position is detected as a phase shift of the waveform.

In FIG. 11, the amplitude (A') of the waveform of the measurement values is smaller than the amplitude (A) of the waveform of the reference values. In this case, the battery 60 is away from the magnetometer 20 without changing the posture of the battery 60 in the reference position. In other words, the installation position of the battery 60 deviates in the Z-axis direction from the reference position while the arrangement plane of the cells 62 remains along the XY plane. The calculation unit 12 may determine that the matching condition is satisfied when the difference between the amplitude of the waveform of the measurement values and the amplitude of the waveform of the reference values is less than an amplitude threshold. Conversely, the calculation unit 12 may determine that the matching condition is not satisfied when the difference between the amplitude of the waveform of the measurement values and the amplitude of the waveform of the reference values is equal to or more than the amplitude threshold. The amplitude threshold may be set as appropriate. As described above, the fact that the battery 60 deviates in the Z-axis direction without changing the posture of the battery 60 in the reference position is detected as a change in the amplitude of the waveform.

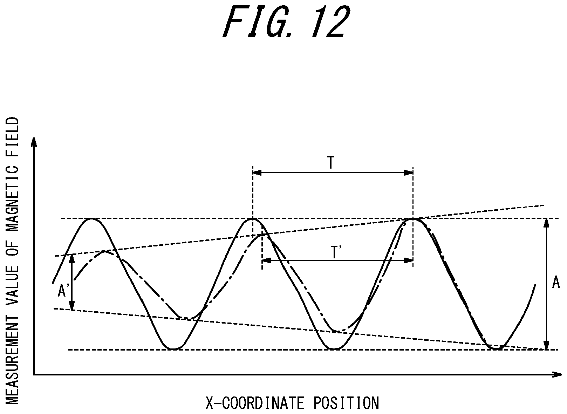

In FIG. 12, the period (T') of the waveform of the measurement values is shorter than the period (T) of the waveform of the reference values. Also, the amplitude (A') of the waveform of the measurement values increases in the positive direction of the X-axis. Conversely, the amplitude (A') of the waveform of the measurement values decreases in the negative direction of the X-axis. The amplitude of the waveform is represented as dashed lines connecting the peaks of the waveform. In this case, the arrangement plane of the cells 62 of the battery 60 is rotated around the Y-axis as illustrated in FIG. 9. The calculation unit 12 may determine that the matching condition is satisfied when the difference between the period of the waveform of the measurement values and the period of the waveform of the reference values is less than a period threshold. Conversely, the calculation unit 12 may determine that the matching condition is not satisfied when the difference between the period of the waveform of the measurement values and the period of the waveform of the reference values is equal to or more than the period threshold. The period threshold may be set as appropriate. The calculation unit 12 may also determine that the matching condition is satisfied when the ratio of a change in the amplitude of the waveform of the measurement values with respect to the X coordinate is less than an amplitude change threshold. Conversely, the calculation unit 12 may determine that the matching condition is not satisfied when the ratio of the change in the amplitude of the waveform of the measurement values with respect to the X coordinate is equal to or more than the amplitude change threshold. The amplitude change threshold may be set as appropriate. As described above, the fact that the battery 60 is rotated around the Y-axis is detected as a change in the period of the waveform or the ratio of the change in the amplitude with respect to the X coordinate.

As described above, the positional misalignments in the X-axis and Z-axis directions and the rotation around the Y-axis are detected.

Other detections include a misalignment in the Y-axis direction and rotations around the X-axis and Z-axis. To detect these misalignment and rotations, the control apparatus 10 controls the magnetometer 20 to scan the battery 60 in a plane by moving the magnetometer 20 along multiple scan paths. The control apparatus 10 can measure the planar distribution of the magnetic field generated by the battery 60 by moving the magnetometer 20 along the multiple scan paths. For example, when the magnetometer 20 is moved in the X-axis direction as the scan direction, the scan unit 14 of the control apparatus 10 may move the magnetometer 20 along the multiple scan paths whose scan start points are shifted in the Y-axis direction. The scan start points are start points of the scan paths of the magnetometer 20, and are positions from which the magnetometer 20 starts to move in the scan direction. In other words, the scan unit 14 may set the scan start point at each of the multiple positions periodically or non-periodically aligned in the direction intersecting the scan direction, and move the magnetometer 20 along the scan direction from each position.

Suppose that positions that serves as the scan start points are set to be the same as the scan start points when the reference values of the magnetic field of the battery 60 are measured. In other words, the multiple scan paths may be set to be the same between when measuring the reference values and when measuring the battery 60 to be determined. The magnetometer 20 may be shifted to each position from which the magnetometer 20 has started moving in the scan direction when the reference values of the magnetic field of the battery 60 have been measured, and moved along the scan direction from each position. Therefore, the control apparatus 10 can compare the measurement values with the reference values with high accuracy.

The multiple scan paths may be set to different paths between when measuring the reference values and when measuring the battery 60 to be determined. In this case, the control apparatus 10 may compare the measurement values with the reference values by complementing the measurement values between the multiple scan paths.

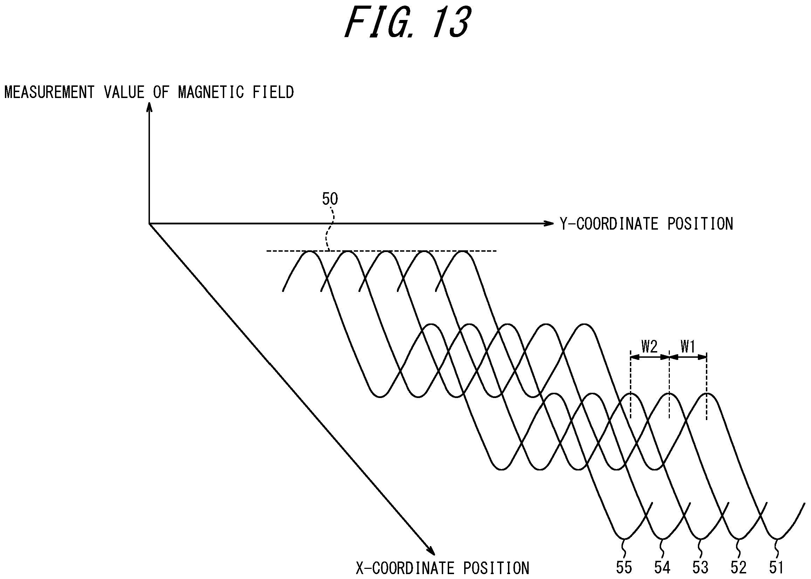

Specifically, as illustrated in FIG. 13, multiple waveforms 51 to 55 of the measurement values are obtained by scanning in the X-axis direction from each of multiple scan start points shifted in the Y-axis direction. The graph in FIG. 13 is a three-dimensional graph representing the magnitude of the measurement values of the magnetic field at each position in the XY plane. Each waveform in the graph of FIG. 13 represents the results of scanning in the X-axis direction. In the three-dimensional graph of FIG. 13, an envelope that connects the measurement values of the magnetic field arranged in the Y-axis direction at a particular X coordinate is generated. The envelope corresponds to a result of scanning in the Y-axis direction, from that X coordinate as a start point. The envelope can be represented as a periodic waveform when intervals between the scan start points shifted in the Y-axis direction are sufficiently shorter than a period in the Y-axis direction. For example, an interval between the scan start point to measure the waveform 51 and the scan start point to measure the waveform 52 is W1 in the Y-axis direction. An interval between the scan start point to measure the waveform 52 and the scan start point to measure the waveform 53 is W2 in the Y-axis direction. By further shortening W1 or W2, the envelope can be represented as a periodic waveform. W1 and W2 may be set to the same value or to different values. An interval in the Y-axis direction between the waveform 53 and the waveform 54 or an interval in the Y-axis direction between the waveform 54 and the waveform 55 may be set to the same value or to different values. The intervals at which the scan start points are shifted in the Y-axis direction may be set to the same value or to different values.

In other words, the intervals of scan measurements can be periodic or random. Each measurement, regardless of whether periodic measurement or randomly spaced measurement, can obtain a different waveform due to the structure of the battery 60. For example, when measuring the front of a module, the measurement value is dominated by the magnetic field generated by the cell 62 located directly in front of the module or the module. However, by measuring the midpoint of modules, the measurement value is influenced by the modules on both sides. In view of the above, the control apparatus 10 may periodically measure the front of modules based on the structure of the device, or may alternately measure the front and the middle of the modules. The control apparatus 10 may measure the magnetic field wherever the control apparatus 10 can measure the magnetic field generated by the modules. However, the measurement positions of the magnetic field shall be the same positions that are defined when measuring the reference values.

The positional misalignment in the Y-axis direction is expressed as the difference between the phase of the waveform of the envelope in the Y-axis direction in the three-dimensional graph of the reference values and the phase of the waveform of the envelope in the Y-axis direction in the three-dimensional graph of the measurement values. The calculation unit 12 may determine that the matching condition is satisfied when the difference between the phase of the waveform of the envelope of the measurement values in the Y-axis direction and the phase of the waveform of the envelope of the reference values in the Y-axis direction is less than a phase threshold. Conversely, the calculation unit 12 may determine that the matching condition is not satisfied when the difference between the phase of the waveform of the envelope of the measurement values in the Y-axis direction and the phase of the waveform of the envelope of the reference values in the Y-axis direction is equal to or more than the phase threshold. The phase threshold may be set to the same value in the X-axis direction and the Y-axis direction, or to different values.

The rotation around the X-axis is expressed as the difference between the amplitude of the waveform of the envelope in the Y-axis direction in the three-dimensional graph of the reference values and the amplitude of the waveform of the envelope in the Y-axis direction in the three-dimensional graph of the measurement values. The calculation unit 12 may determine that the matching condition is satisfied when the difference between the amplitude of the waveform of the envelope of the measurement values in the Y-axis direction and the amplitude of the waveform of the envelope of the reference values in the Y-axis direction is less than an amplitude threshold. Conversely, the calculation unit 12 may determine that the matching condition is not satisfied when the difference between the amplitude of the waveform of the envelope of the measurement values in the Y-axis direction and the amplitude of the waveform of the envelope of the reference values in the Y-axis direction is equal to or more than the amplitude threshold. The amplitude threshold may be set to the same value in the X-axis direction and the Y-axis direction, or to different values.

The rotation around the Z-axis is expressed as an angle that a ridge line 50 connecting peaks of the waveforms 51 to 55 in the three-dimensional graph of the measurement values forms with the Y-axis direction. The calculation unit 12 may determine that the matching condition is satisfied when the angle of the ridge line 50 with respect to the Y-axis is less than an angle threshold. Conversely, the calculation unit 12 may determine that the matching condition is not satisfied when the angle of the ridge line 50 with respect to the Y-axis is equal to or more than the angle threshold. The angle threshold may be set as appropriate.

As described above, the matching condition is set so that the positional and postural misalignments of the battery 60 from the reference position are less than a determination threshold.

Returning to the flowchart in FIG. 4, when the difference between the reference values of the magnetic field of the battery 60 and the measurement values thereof satisfies the matching condition (step S3: YES), the control apparatus 10 proceeds to step S7. When the difference between the reference values of the magnetic field of the battery 60 and the measurement values thereof does not satisfy the matching condition (step S3: NO), the control apparatus 10 calculates, by the calculation unit 12, information regarding the relative position of the magnetometer 20 (step S4). When the battery 60 is in the normal state and the same current as when measuring at the reference position flows, the difference between the waveform of the measurement values of the magnetic field of the battery 60 and the waveform of the reference values thereof is caused by a difference in the relative position between the battery 60 or the device with the battery 60 and the magnetometer 20. In other words, the calculation unit 12 may calculate the magnitude of the misalignment of the battery 60 in the X-, Y-, or Z-axis direction, based on the difference between the reference values of the magnetic field of the battery 60 and the measurement values thereof, as the information regarding the relative position of the magnetometer 20. The calculation unit 12 may calculate an angle of the rotation of the battery 60 around the X-axis, Y-axis, or Z-axis, as the information regarding the relative position of the magnetometer 20. The angle of the rotation of the battery 60 around the X-axis, Y-axis, or Z-axis represents the magnitude of the postural misalignment of the battery 60.

The calculation unit 12 may calculate a correction coefficient as the information regarding the relative position of the magnetometer 20. The correction coefficient is used to correct the positional or postural misalignment of the battery 60. The correction coefficient may be used to correct the waveform of the measurement values of the magnetic field of the battery 60 to the waveform when the battery 60 is positioned at the reference position.

The calculation unit 12 may calculate a pattern representing the difference between the waveform of the reference values of the magnetic field of the battery 60 and the waveform of the measurement values thereof as the information regarding the relative position of the magnetometer 20. The calculation unit 12 may calculate the pattern representing the difference between the three-dimensional waveform of the reference values and the three-dimensional waveform of the measurement values. In other words, the calculation unit 12 may recognize, as the pattern, the difference between the waveform of the reference values and the waveform of the measurement values.

The control apparatus 10 determines, by the determination unit 13, whether the information regarding the relative position of the magnetometer 20 satisfies an anomaly determination condition (step S5). The anomaly determination condition is set to be satisfied when the battery 60 is not in the normal state. For example, even when the measurement values do not coincide with or deviate significantly from the reference values, the determination unit 13 may determine that the battery 60 is in the normal state as long as the determination unit 13 can identify how the battery 60 deviates from the reference position.

Specifically, the difference between the measurement values of the magnetic field and the reference values thereof when the battery 60 is in the normal state is caused by the difference in the relative position of the magnetometer 20. In other words, the difference between the measurement values and the reference values is caused by the positional or postural misalignment of the battery 60. In this case, the correction coefficient is calculated as a value proportional to the positional or postural misalignment of the battery 60. Then, the determination unit 13 may determine that the battery 60 is in the normal state when the magnitude of the positional or postural misalignment determined based on the correction coefficient is within, for example, the interior of the device on which the battery 60 is mounted. Conversely, the determination unit 13 may determine that the battery 60 is not in the normal state when the magnitude of the positional or postural misalignment determined based on the correction coefficient is physically impossible, for example, exceeds the size of the device on which the battery 60 is mounted. The determination unit 13 may determine that the battery 60 is normal when the correction coefficient is less than a determination threshold, and determine that the battery 60 is not normal when the correction coefficient is equal to or more than the determination threshold. In other words, the anomaly determination condition may be that the correction coefficient is equal to or more than the determination threshold. The determination threshold may be set as appropriate based on, for example, the size or the like of the device on which the battery 60 is mounted.

When calculating the pattern representing the difference between the waveform of the reference values and the waveform of the measurement values as the information regarding the relative position of the magnetometer 20, the determination unit 13 may determine whether the pattern corresponds to a pattern in which the battery 60 is in the normal state or not in the normal state. The determination unit 13 may determine the state of the battery 60 by pattern matching. The determination unit 13 may determine the state of the battery 60 using a model that outputs the state of the battery 60 upon inputting the pattern. In other words, the anomaly determination condition may be that the pattern representing the difference between the waveform of the reference values and the waveform of the measurement values is different from the pattern when the battery 60 is in the normal state.

When, as the measurement values of the magnetic field of the battery 60, results that are not possible based on the structure of the device on which the battery 60 is mounted are obtained, the determination unit 13 may determine that the battery 60 is not in the normal state, regardless of the correction coefficient. For example, when the measurement values do not coincide with the reference values in the database, when the correction coefficient cannot be calculated, or when the correction coefficient is outside a predetermined range, the determination unit 13 may determine that the battery 60 is not in the normal state. In other words, the anomaly determination condition may include cases in which the measurement values do not coincide with the reference values in the database, in which the correction coefficient cannot be calculated, or in which the correction coefficient is outside the predetermined range.

Cases in which the battery 60 is not in the normal state may include, for example, when the battery 60 mounted in the device is not genuine, when the battery 60 is faulty, or when the position of the battery 60 is outside the range in which the magnetometer 20 can measure the magnetic field.

When the information regarding the relative position of the magnetometer 20 does not satisfy the anomaly determination condition (step S5: NO), the control apparatus 10 corrects, by the calculation unit 12, the measurement values of the magnetic field of the battery 60 (step S6). Specifically, the calculation unit 12 corrects the measurement values of the magnetic field of the battery 60 based on the information regarding the relative position of the magnetometer 20. The calculation unit 12 may correct the measurement values of the magnetic field of the battery 60 based on the correction coefficient.

The control apparatus 10 determines that the battery 60 is in the normal state (step S7) when the matching condition is satisfied in the matching condition determination process in step S3, or when the anomaly determination condition is not satisfied in the anomaly determination condition determination process in step S5, after performing the process in step S6. On the other hand, the control apparatus 10 determines that the battery 60 is in an anomalous state (step S8) when the anomaly determination condition is satisfied in the anomaly determination condition determination process in step S5 (step S5: YES). The control apparatus 10 ends the execution of the procedure of the flowchart in FIG. 4 after the execution of the process of step S7 or S8.

When the anomaly determination condition is satisfied in the anomaly determination condition determination process in step S5 of the flowchart in FIG. 4, the control apparatus 10 determines that the battery 60 is anomalous, without correcting the measurement values of the magnetic field. This eliminates unnecessary correction operations. As a result, an operation load of the control apparatus 10 is reduced.

### (Summary)

As described above, in the method of determining the state of the battery 60 according to this embodiment, the information regarding the relative position of the battery 60 is calculated based on the difference between the reference values of the magnetic field of the battery 60 and the measurement values thereof, and the measurement values are corrected. This allows the positional or postural misalignment of the battery 60 relative to the magnetometer 20. As a result, even when it is difficult to adjust the position of the battery 60 relative to the magnetometer 20 while the battery 60 is still mounted on the device, the magnetic field of the battery 60 is measured with high accuracy, without removing the battery 60 from the device. For example, the method of determining the state of the battery 60 according to the present disclosure is effective when it is difficult to remove the battery 60 from the device, such as when the battery 60 is mounted on an electric vehicle. By determining the state of the battery 60 while the battery 60 is still mounted on the device, accuracy in determining the state of the battery is improved without increasing a measurement burden of the battery.

### (Other Embodiments)

The battery state determination system 1 and the method of determining the state of the battery 60 according to other embodiments will be described below.

### <Preliminary Diagnosis>

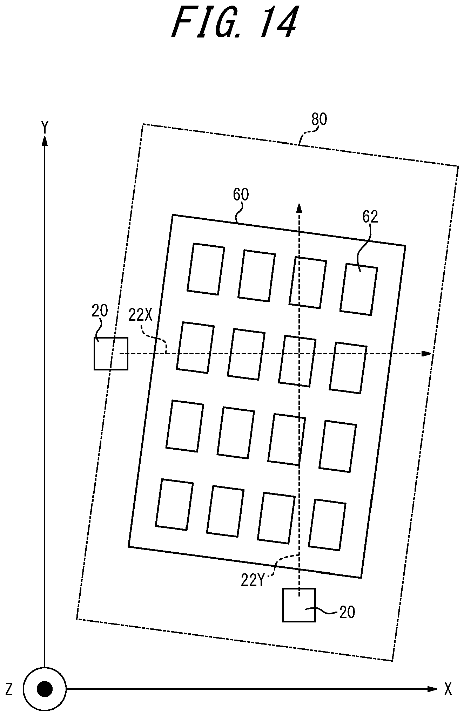

The arrangement of the cells 62 of the battery 60 may be unknown. In this case, as illustrated in FIG. 14, the control apparatus 10 may control the magnetometer 20 to preliminarily scan the battery 60 in each of a scan direction 22X along the X-axis and a scan direction 22Y along the Y-axis, to acquire measurement values in each scan direction. The control apparatus 10 may estimate the arrangement of the cells 62 of the battery 60 based on the measurement values in the scan directions, and determine the scan direction of the magnetometer 20 according to the estimated arrangement. By determining the scan direction of the magnetometer 20 based on the preliminary measurements, the magnetometer 20 is moved so that the position of the battery 60 is closer to the reference position. As a result, the positional or postural misalignment of the battery 60 is reduced. A sensor used to preliminarily measure the magnetic field of the battery 60 may be the same as or different from the magnetometer 20 used to obtain the measurement values of the magnetic field for the purpose of determining the state of the battery 60.

In other words, the control apparatus 10 may move the magnetometer 20 in each of multiple directions, including at least first and second directions, to acquire the measurement values of the magnetic field of the battery 60. Here, the first direction may correspond to the X-axis direction. The second direction may correspond to the Y-axis direction. The control apparatus 10 may estimate the arrangement of the cells 62 based on first measurement values obtained by moving the magnetometer 20 in the first direction and second measurement values obtained by moving the magnetometer 20 in the second direction, and determine the scan direction of the magnetometer 20.

When the battery 60 is mounted on a vehicle, the position of the battery 60 and the arrangement of the cells 62 are determined for each vehicle model. The control apparatus 10 may identify a vehicle model based on an image of the vehicle on which the battery 60 is mounted, and determine the scan direction and a scan range of the magnetometer 20, based on the position of the battery 60 and the arrangement of the cells 62. In other words, the control apparatus 10 may move the magnetometer 20 in the scan range that is determined based on the type of the device on which the battery 60 is mounted. This eliminates unnecessary scanning. As a result, measurement efficiency is increased.

### <Position Adjustment>

In the embodiment described above, when the position of the battery 60 deviates from the reference position, the control apparatus 10 does not adjust the position of the battery 60 or the magnetometer 20, but responds by correcting the measurement values. In other embodiments, the position of the battery 60 or the magnetometer 20 may be adjusted.

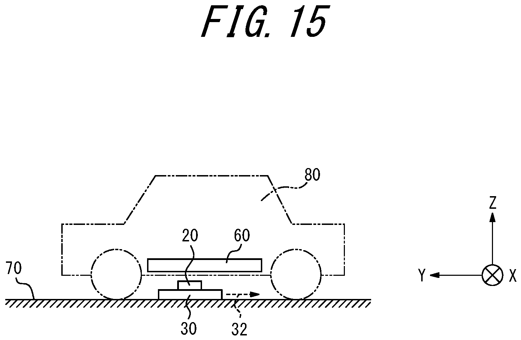

As illustrated in FIG. 15, the battery state determination system 1 may further include a movement apparatus 30. The magnetometer 20 may be mounted on the movement apparatus 30. The movement apparatus 30 is configured to move along the ground 70, for example. The movement apparatus 30 may be configured to move in the vertical direction. The control apparatus 10 may move, by the scan unit 14, the magnetometer 20 so that the scan range of the magnetometer 20 is the same as that when the battery 60 is positioned at the reference position, by controlling the scan direction of the magnetometer 20 in accordance with the positional or postural misalignment of the battery 60.

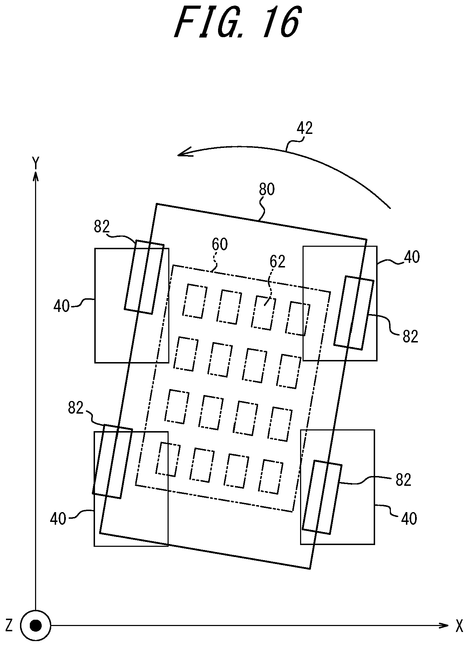

As illustrated in FIG. 16, the battery state determination system 1 may further include a drive apparatus 40. The drive apparatus 40 is configured to be able to drive the device, e.g., the vehicle 80 on which the battery 60 is mounted, relative to the ground 70. In the example of FIG. 16, the drive apparatus 40 drives the posture of the battery 60 from a state in which the arrangement of the cells 62 is inclined with respect to the X-axis and Y-axis to a state in which the arrangement of the cells 62 is along the X-axis and Y-axis, by moving the tires 82 of the vehicle 80 along the ground 70. The drive apparatus 40 adjusts the position and posture of the battery 60 relative to the magnetometer 20.

The control apparatus 10 may re-perform the measurements of the magnetic field of the battery 60 by scanning by the magnetometer 20 after the adjustment of the positions of the battery 60 and the magnetometer 20 as described above. In other words, the control apparatus 10 may physically correct the relative position of the magnetometer 20, and then re-perform the measurements of the magnetic field. This increases the measurement accuracy of the magnetic field or the accuracy in determining the state of the battery 60.

When the device on which the battery 60 is mounted is a low-floor vehicle 80, the magnetometer 20 may be installed to scan the bottom of the vehicle 80 in a space hollowed out of the ground 70, which is lower than a ground surface of the tires 82.

The control apparatus 10 may use a distance measurement sensor to calculate the relative position between the battery 60 and the magnetometer 20.

Although the embodiments according to the present disclosure have been described based on the drawings and examples, it should be noted that one skilled in the art can make various variations or modifications based on the present disclosure. Accordingly, it should be noted that these variations or modifications are included in the scope of the present disclosure. For example, the functions included in each component or step can be rearranged so as not to be logically inconsistent. A plurality of components or steps can be combined into one, or each component or step can be divided.

## Claims

1. A battery state determination method comprising:
acquiring a measurement value of a magnetic field of a battery (60) mounted on a device, the measurement value being measured by a magnetometer (20);
calculating information regarding a relative position of the magnetometer (20), based on the measurement value of the magnetic field of the battery (60) and a reference value of the magnetic field of the battery (60); and
determining a state of the battery (60) based on the information regarding the relative position of the magnetometer (20).

2. The battery state determination method according to claim 1, comprising determining that the battery (60) is anomalous when the information regarding the relative position of the magnetometer (20) satisfies an anomaly determination condition.

3. The battery state determination method according to claim 1 or 2, comprising calculating, as the information regarding the relative position of the magnetometer (20), a correction coefficient for the relative position of the magnetometer (20).

4. The battery state determination method according to any one of claims 1 to 3, comprising moving the magnetometer (20) along one scan direction (22), to measure the magnetic field of the battery (60) by the magnetometer (20).

5. The battery state determination method according to claim 4, comprising shifting the magnetometer (20) to each of multiple positions that are aligned periodically or non-periodically in a direction intersecting the scan direction (22), and moving the magnetometer (20) from each of the positions along the scan direction (22).

6. The battery state determination method according to claim 5, comprising shifting the magnetometer (20) to each position from which, when the reference value of the magnetic field of the battery (60) has been measured, movement to the scan direction (22) has been started, and moving the magnetometer (20) from each position along the scan direction (22).

7. The battery state determination method according to any one of claims 4 to 6, comprising:
acquiring measurement values of the magnetic field of the battery (60) by moving the magnetometer (20) to multiple directions including at least first and second directions; and
determining the scan direction (22) based on a first measurement value and a second measurement value, the first measurement value being obtained by moving the magnetometer (20) to the first direction, the second measurement value being obtained by moving the magnetometer (20) to the second direction.

8. The battery state determination method according to any one of claims 4 to 7, comprising moving the magnetometer (20) in a scan range determined based on a type of the device on which the battery (60) is mounted.

9. A battery state determination system (1) comprising:
a magnetometer (20); and
a control apparatus (10) configured to perform the battery state determination method according to any one of claims 1 to 8.

10. The battery state determination system (1) according to claim 9, further comprising:
a movement apparatus (30) configured to move the magnetometer (20) relative to the battery (60),
wherein the movement apparatus (30) is configured to move between a plane on which the device with the battery (60) is disposed and the battery (60).

11. The battery state determination system (1) according to claim 9 or 10, further comprising a drive apparatus (40) configured to move the device with the battery (60) relative to the magnetometer (20).

12. The battery state determination system (1) according to any one of claims 9 to 11, wherein the magnetometer (20) is configured to include one or more magnetic sensors to measure the magnetic field of the battery (60).

13. The battery state determination system (1) according to claim 12, wherein the magnetometer (20) is configured to include a plurality of the magnetic sensors arranged in a line or array.

14. The battery state determination system (1) according to claim 12 or 13, wherein the magnetometer (20) is configured to include a plurality of the magnetic sensors arranged in a range of covering entirety of the battery (60).

15. The battery state determination system (1) according to claim 14, wherein the control apparatus (10) is configured to select part of the plurality of the magnetic sensors, and acquire measurement values from the selected magnetic sensors.
